# EUROPEAN PATENT SPECIFICATION

(11) **EP 1 605 505 B1**
(45) Date of publication and mention of the grant of the patent: **23.04.2008**
(21) Application number: 04291472.1
(22) Date of filing: 11.06.2004
(51) Int. Cl.: H01L 21/762, H01L 21/20, H01L 21/66

(54) **Method for manufacturing a material compound wafer**
Verfahren zur Herstellung eines Verbundsubstrats
Procédé de fabrication d'un substrat composé

(43) Date of publication of application: 14.12.2005
(73) Proprietor: S.O.I.TEC Silicon on Insulator Technologies S.A., 38190 Bernin (FR)
(72) Inventor: Maurice, Thibaut, 38100 Grenoble (FR); Guiot, Eric c/o Résidence de Porte Paillac, 38570 Goncelin (FR)
(74) Representative: Grünecker, Kinkeldey, Stockmair & Schwanhäusser Anwaltssozietät

(56) References cited:
- ASPAR B ET AL: "SMART-CUT TECNOLOGY: AN INDUSTRIAL APPLICATION OF ION IMPLENTATION INDUCED CAVITIES" MATERIALS RESEARCH SOCIETY SYMPOSIUM PROCEEDINGS, MATERIALS RESEARCH SOCIETY, PITTSBURG, PA, US, vol. 510, 13 April 1998 (1998-04-13), pages 381-393, XP000884996 ISSN: 0272-9172
- MALEVILLE C ET AL: "Wafer bonding and H-implantation mechanisms involved in the Smart-cut(R) technology" MATERIALS SCIENCE AND ENGINEERING B, ELSEVIER SEQUOIA, LAUSANNE, CH, vol. 46, no. 1-3, April 1997 (1997-04), pages 14-19, XP004085270 ISSN: 0921-5107
- LAGAHE C ET AL: "A parallel between silicon spliffing kinetics study and IR absorption analysis" 2001 IEEE INTERNATIONAL SOI CONFERENCE PROCEEDINGS. DURANGO, CO, OCT. 1 - 4, 2001, IEEE INTERNATIONAL SOI CONFERENCE, NEW YORK, NY : IEEE, US, 1 October 2001 (2001-10-01), pages 69-70, XP010563634 ISBN: 0-7803-6739-1
- PATENT ABSTRACTS OF JAPAN vol. 1997, no. 12, 25 December 1997 (1997-12-25) -& JP 09 213652 A (SEMICONDUCTOR ENERGY LAB CO LTD; SHARP CORP), 15 August 1997 (1997-08-15)
- ASPAR B ET AL: "THE GENERIC NATURE OF THE SMART-CUT PRCESS FOR THIN FILM TRANSFER" JOURNAL OF ELECTRONIC MATERIALS, WARRENDALE, PA, US, vol. 30, no. 7, 22 January 2001 (2001-01-22), pages 834-840, XP001050558

## Description

### FIELD OF THE PRESENT INVENTION

The invention relates to a method for manufacturing a material compound wafer, in particular a heterogeneous material compound, more particularly a heterogeneous material compound comprising at least two materials with different physical and/or chemical properties, in particular with different thermal expansion coefficients, comprising the steps of: forming a predetermined splitting area in a source substrate, attaching the source substrate to a handle substrate to form a source handle compound, and thermal annealing of the source substrate for weakening of the source substrate at the predetermined splitting area.

The use of material compound wafers, like silicon on insulator (SOI) or silicon on quartz (SOQ) wafers, becomes more and more widespread in the manufacturing process of modern electronic, optoelectronic or micromechanical devices. Therein use is made of the different physical or chemical properties of the at least two materials that are attached together in such a structure. For example, in the case of an SOQ wafer, a thin silicon layer is provided on a quartz plate so that in an optoelectronic application electronic circuits can be developed in and on the semiconducting silicon layer and at the same time the quartz substrate can be used as being the cover of the electronic device through which light can enter or exit the device.

To make such material compound wafers not only technologically interesting, but also economically viable, it becomes necessary to provide a manufacturing process of these material compound wafers that is capable of producing high quality material compound wafers, like the SOQ wafers, but which at the same time are also economically viable.

In the case of SOI wafers one example of such a suitable manufacturing process is based on the so-called Smart Cut technology comprising the following process steps: implanting atomic species in a source substrate thereby forming an in-depth weakened layer corresponding to a predetermined splitting area, then bonding the source substrate to a handle substrate and finally performing a splitting step, which is achieved by providing thermal and/or mechanical energy to the source-handle-compound, whereby the splitting occurs along the weakened area. With this process a thin layer from the source substrate is transferred onto the handle substrate. Usually a final treatment takes place to obtain a surface quality suitable for the application.

It is known that with raising temperature the implanted layer becomes weaker and weaker, wherein the strength of the bonding interface gets stronger. So that the transfer of the thin layer onto the handle substrate becomes possible from a certain temperature onwards. Y. Cho, N.W. Cheung "Low temperature Si layer transfer by direct bonding and mechanical ion cut" (Appl. Phys. Lett, 83, 18, 3 November 2003) measured those forces with a probe destructive method by introducing a razor blade into the bonded structure to achieve a detachment either at the bonding interface or the implanted layer and determined therefrom an estimate of the necessary surface energy which is related to the strength of the bonding interface and the implanted layer.

From Aspar B et al, Materials Research Society Symposium Proceedings, vol. 510, pages 381 to 393, 13 April 1998, "Smart-Cut Technology: An Industrial Application of Ion Implantation Induced Cavities" it is known to carry out IR absorption measurements to characterize the status of the bonds in a splitting area. From Maleville C et al, Materials Science and Engineering B, vol. 46, no. 1-3, pages 14-19, April 1997, "Wafer bonding and H-implantation mechanisms involved in the Smart-Cut technology" it is known to use transmission electron microscopy observations to investigate the splitting areas in Smart-Cut SOI wafers.

In the case of hetero structures, more in particular in the case of hetero structures being composed of materials having different characteristics, in particular different thermal extension coefficients, the above mentioned splitting step is usually carried out in two separate steps. A first annealing step to further weaken the predetermined splitting area and a detachment step during which either thermal or mechanical energy is provided to the weakened area to achieve the actual detachment of the two structures. This separation in two steps is necessary as due to different thermal expansion coefficients mechanical stress occurs in the bonded source-handle-compound which leads to a reduction of production yield, as the hetero structure may break due the internal stress at an elevated temperature.

However, with the economical pressure on the prices of wafers being extremely high the production yield for the production of material compound wafers, in particular heterogeneous material compound wafers, achieved with the above described method is not sufficient.

It is therefore an object of the present invention to provide a manufacturing method for a material compound wafer, in particular a heterogeneous material compound wafer, for which the production yield and quality of the final product is further enhanced.

This object is achieved with the method for manufacturing a material compound wafer, in particular a heterogeneous material compound wafer, according to claim 1.

By determining the degree of weakening, the operator carrying out the manufacturing method is supplied with additional data informing him about the status of the maturity of the weakening. The term "weakening" herein is describing the physical strength of the connection between the two parts of the source substrate which are to be detached at the predetermined splitting area. In the case of the Smart Cut technology, the weakening occurs due to the implantation of the atomic species. The term "degree of weakening" in this application is employed as a measure of the strength of the weakened predetermined splitting area, when the two parts of the source substrate with the splitting area in between are still connected to each other and therefore this term does not comprise the state when complete detachment between the two parts of the source substrate is achieved. In fact the degree of weakening is thus determined prior to complete detachment.

According to a preferred embodiment, the degree of weakening can be determined in-situ. Thus during the thermal annealing step, in particular during the whole thermal annealing step, the degree of weakening can be continuously measured. By doing this eventual anomalies in the weakening process can be detected at an early stage so that an eventual damage of the source substrate or the source-handle-compound can be prevented. The thermal annealing step may be carried out until complete detachment of the source substrate at the predetermined splitting area from the source-handle-compound is achieved or the annealing step is stopped prior to complete detachment whereby in a following process step further energy can be supplied to split the source substrate from the source handle compound.

Advantageously, the thermal annealing step can be stopped, in particular automatically, when the degree of weakening corresponds to a predetermined value. Actually with the determination of the degree of weakening it becomes possible to control the thermal annealing step as a function of the actual weakening that occurs inside the source handle substrate.

The degree of weakening is determined more than once, in particular continuously or periodically, and depending on the evolution of the degree of weakening the duration and/or the annealing temperature is/are adapted. This gives the advantage that an optimization of the thermal annealing process step can be achieved by this controlling and leads to a better quality of the weakening and therefore in the end to a better quality of the end product and/or a higher production yield.

According to an advantageous embodiment the degree of weakening can be determined by measuring an optical property of the source substrate, in particular of the weakened predetermined splitting area. Measuring optical properties has the advantage that it is a non-destructive characterization technique and that furthermore no special preparation of the probe, in this case the source-handle-compound needs to be performed prior to carry out the measurements. In addition optical measurements are usually easy to install.

Preferably, the optical property can be measured in the visible range and/or in the x-ray range, in particular the soft x-ray range, and/or in the infrared range. Depending on the properties of the source substrate and eventually the handle substrate, the most suited electromagnetic wave spectrum can be chosen. The visible range is in particular applicable for SOQ wafers with the quartz being transparent and has the advantage that light sources and detectors are widespread and of relatively low cost. Infrared light can advantageously be employed with a silicon support substrate for measuring the weakening, in particular in the case of ultra thin SOI structures. X rays have the advantage that the probe does not have to be transparent.

In a further variant, the degree of weakening can be determined by measuring the reflectivity or the transmission of the source handle compound, in particular of the weakened predetermined splitting area. The measurement of the reflectivity consists in irradiating the sample, in this case the source handle compound, and measuring the light intensity reflected back. By analyzing the measured reflectivity insight is obtained on the physical properties of the irradiated material. In particular use is made of the optical constants of the employed materials to characterize the probe. In the example of the Smart Cut technology, it becomes possible to obtain information about degree of weakening in the predetermined splitting area during the thermal annealing. In contrast to measuring the reflectivity, it may also be a possibility to measure the transmission thus the light which does not become reflected, nor absorbed while traveling through the source-handle-compound. Transmission measurements are in particular suitable for a single wafer furnace and reflectivity measurements for batch systems.

Advantageously, the degree of weakening can be determined by comparing the measured optical property during and/or after the thermal annealing step with the measured optical property prior to the thermal annealing. In particular when the evolution of the degree of weakening is looked at, the relative change of the optical property, for instance the reflectivity, which can be easily obtained by dividing the measured value by the value of the optical property prior to annealing, already gives insight into the evolution of the weakening of the predetermined splitting area, without the necessity to determine the reflectivity on an absolute scale.

Advantageously, the reflectivity or transmission can be measured with one wavelength. This is easy to realize by, for instance, using a solid state laser diode in the visible range. Furthermore data treatment is also simplified.

In a variant, the reflectivity or transmission can be measured in a predetermined range of wavelengths, in particular from 400nm to 1600nm or in the case of infrared 100nm to 3000nm. Compared to measuring one wavelength only, measurement of a whole spectrum gives more insight into the changes occurring in the predetermined splitting area during the thermal annealing.. Analyzing the reflectivity spectrum over a large range of wavelengths gives the possibility to quantify the observed effect and to obtain better information about the maturity of the weakening.

According to an advantageous embodiment, the handle substrate can be transparent and the degree of weakening can be determined by performing measurements through the handle substrate. As mentioned above, depending on the degree of weakening the colour of the source substrate, in particular on the surface of the source substrate which is close to the predetermined splitting area, is changing. As this surface is bonded to the handle substrate it is advantageous, especially in the case when visible light is used, to employ a transparent handle substrate such that the measurements can be performed through the handle substrate. Thus the method is in particular advantageous in the case of a quartz or glass substrate.

In addition, the invention provides a thermal annealing device being used in the manufacturing process of the material compound wafer for weakening a source substrate at the predetermined splitting area characterized in further comprising a means for determining a degree of weakening characterizing the physical strength of the weakened predetermined splitting area, during and/or after the thermal annealing. With the means of determining the degree of weakening, it thus becomes possible to obtain additional information about the state of the strength of the predetermined splitting area and thereby it becomes possible to better control the manufacturing process such that the end product, a material wafer compound, has a better quality or that the production yield becomes enhanced.

In an advantageous embodiment the means for determining the degree of weakening can comprise a reflectometer or an ellipsometer. Advantageously the degree of weakening is determined by measuring the reflectivity, or eventually a transmission.

In a further variant, the thermal annealing device can comprise a control means for analyzing the evolution of the degree of weakening, which can be measured several times, in particular continuously, and based on this analysis adapting the thermal annealing process, for example by adapting the annealing temperature or the annealing duration.

The invention also relates to the use of a device determining the degree of weakening according to the method of one of claims 1 to 11 in a thermal annealing device. Thus the advantageous method can also be carried out in a standard thermal device which according to the invention can be equipped with the device for determining the degree of weakening

In the following an example of the inventive process for manufacturing material compound and a thermal annealing device used in this manufacturing process are described with respect to the Figures:
Fig. 1 a-g show an embodiment of the method for manufacturing a material compound wafer, in particular a heterogeneous material compound wafer, wherein a degree of weakening is determined during the thermal annealing step,
Fig. 2 shows an embodiment of the inventive thermal annealing device, and
Fig. 3 shows an example of a reflectivity spectrum measured prior to thermal annealing and during thermal annealing, and which shows the change in reflectivity which is characteristic for the evolution of the degree of weakness in the case of a SOQ wafer.

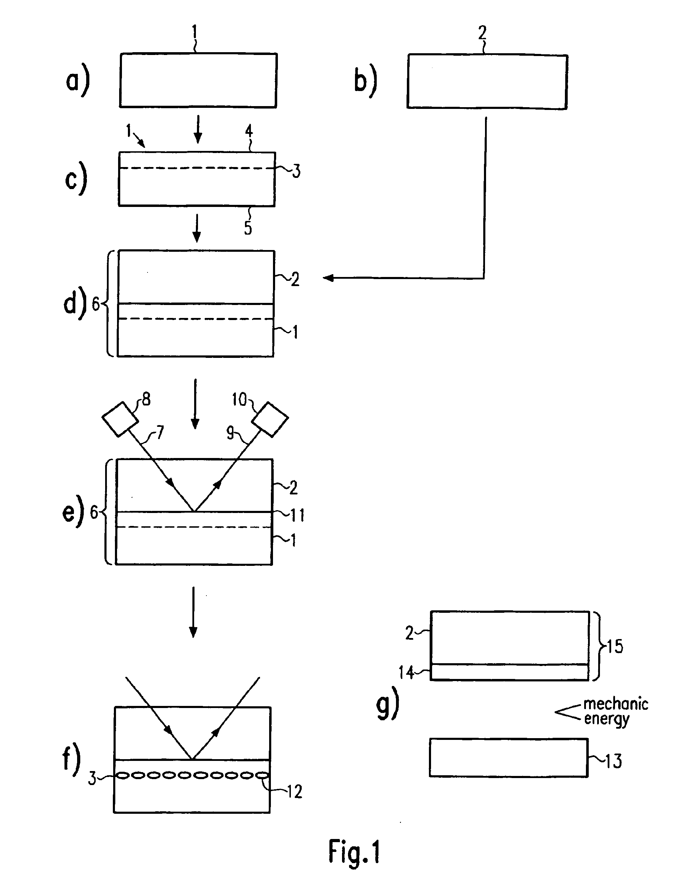

Figs. 1a - 1g illustrate one embodiment of manufacturing a material compound wafer, in particular in this case a silicon on quartz (SOQ) heterogeneous material compound wafer, according to the Smart Cut technology. Of course the SOQ material compound wafer only represents one possible example of a material compound wafer and others like GaN, SiC, GeOl, SiGe or eventually also SOI can also be manufactured with the method as disclosed in the following.

Fig. 1 a shows a wafer 1 serving as a source substrate. From this source substrate wafer 1 a thin layer will be transferred to a handle substrate 2 shown in Fig. 1 b. In the case of SOQ the source wafer 1 is a standard silicon wafer usually with diameters of currently up to 300 mm and the handle substrate wafer 2 is a quartz wafer. Other possible wafer materials are e.g. III-V type wafers, like gallium arsenide (GaAs), indium phosphite (InP), or gallium nitride (GaN), but also germanium (Ge) or fused silica, with the list not being exclusive. The process can be carried out with bare wafers or eventually one or more layers may be provided on one or both of the source and the handle wafer 1, 2, prior to carrying out the inventive process. Such additional layers could, for example, be a silicon dioxide layer.

The next step in the process is shown in Fig. 1c which consists of implanting atomic species, such as for example hydrogen, helium and/or other rare gasses, in particular in a ionic state, with energies in the range of approximately 30 - 210 keV and an implanting dose in a range of about 5 x 10¹⁵ to 1 x 10¹⁷ at/cm² in case of hydrogen in order to form a predetermined splitting area 3 in the source substrate wafer 1, according to the first step according to claim 1. This layer-like predetermined splitting area 3 is buried inside the source substrate 1 and essentially parallel to the main surfaces 4, 5 of the source substrate 1. The splitting area is at a distance from one of the main surfaces, in this case main surface 4, depending on the energy of the atomic species and the substrate material.

In the next step, illustrated in Fig. 1d, the handle substrate 2 and the source substrate 1 are bonded together to form a source-handle-compound 6, according to the second manufacturing step according to claim 1. One possible bonding mechanism takes place due to Van de Waals interaction. In a subsequent annealing step the strength of the bonding is enhanced. However, other bonding techniques, depending on the employed materials, can also be applied.

Usually the next process step consists in carrying out a thermal annealing step according to the third process step according to claim 1. In the illustrated inventive embodiment, however, prior to starting the thermal annealing step a first reflectivity measurement is carried out. As shown in Fig. 1e the source handle compound 6 is illuminated with a light beam 7 which is traveling through the transparent handle substrate 2 and is reflected at the interface 11 between the handle substrate 2 and the source substrate 1. The reflected light 9 travels back through the handle substrate 2 and is captured by a detector 10.

This measurement can actually be performed in several ways, examples of which will be given in the following. First of all the light source 8 can be a light source having only one wavelength or a light source of which using a filter all but one wavelength are filtered out such that only one wavelength impinges on the source handle compound 6. Here the term "one wavelength" should be understood in the broad sense, meaning that e.g. a laser always has a certain wavelength range, which however is restricted compared to broad spectrum light sources. In another variant the light source 8 can be a light source having a certain range of wavelengths, thus illuminating the source handle compound 6 with several wavelengths. The same is valid concerning the detector 10 which may be a detector only analyzing one particular wavelength, or could be a detector analyzing a range of wavelengths. In addition to the light source 8 and the detector 10 a whole set of optical elements, such as lenses or filters, may also be employed in order to improve the reflectivity measurement.

The reflectivity or transmission can be measured in a predetermined range of wavelengths, in particular from 400 nm to 1600 nm or in the case of infrared 100 nm to 3000 nm.

Furthermore the reflectivity could be measured by illuminating the whole-source-handle interface 11 and analyzing the reflected light, reflected from the entire interface 11, or only a part of the source handle interface 11 may be irradiated and the reflected light from that irradiated part of the interface be analyzed. Furthermore, it is also possible to irradiate several parts of the interface 11 at different positions and analyzing the reflected light from all of these different positions. This could be performed either by providing several light sources in parallel together with several detectors in parallel, or by subsequently measuring different positions by providing a moveable mirror system in the optical path such that the position where the light impinges on the handle source interface 11 can be moved from one location to the other.

Typical light sources suitable for the application comprise single wavelength light sources, like laser diodes, or wider range wavelength light sources , and suitable detectors.

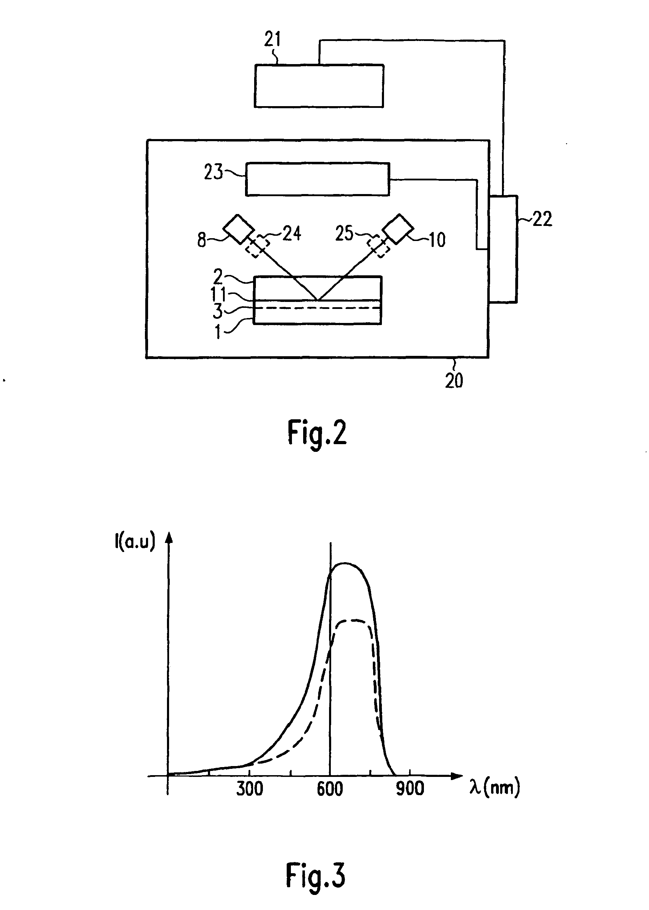

An example for a measured reflectivity spectrum will be shown and explained in detail with respect to Fig. 3.

The next step in the process then may consist of the thermal annealing step carried out for weakening the source substrate 1 at the predetermined splitting area 3. This step is usually carried out at a temperature in a range of about 200°C to 500°C and lasts from about a couple of minutes to a couple of hours. But this is very specific to the given material, the nature of the implanted species, the energy and dose. Due to the fact that the hetero structure, like SOQ, is made out of two different materials, having in particular different thermal expansion coefficients it happens that during the annealing the silicon tends to expand much more than the quartz leading to stress inside the source-handle-compound. The thermal energy helps to weaken the predetermined splitting area. To prevent that due to the stress inside the source-handle-compound 6 undesired damaging of the structure occurs the inventive method proposes to determine the degree of weakening, which is actually characterizing the physical strength of the weakened predetermined splitting area, during and/or after the thermal annealing step. This degree of weakening being known, the thermal annealing can be terminated prior to the occurrence of breaking or damaging due to stress.

In the embodiment the degree of weakening is obtained by measuring the reflectivity during the thermal annealing step, as illustrated in Fig. 1f. The way the reflectivity spectrum is measured corresponds to the one already described with respect to Fig. 1 e. The obtained spectrum can then be compared to the one measured prior to the thermal annealing step or compared to a predetermined reference spectrum.
In a variant, the information obtained from the reflectivity measurements can be used to identify when the thermal annealing step needs to be stopped. This can for example be automatically done by comparing the obtained degree of weakening with a predetermined value. If, for example, the reflectivity is measured with only one wavelength and the degree of weakening is obtained by dividing the measured intensity during the thermal annealing by the measured intensity value prior to thermal annealing, it may be decided to stop the annealing step when this value reaches a certain value, like e.g. 75%.

The evolution of the degree of weakening is used to control the annealing step by adapting temperature and duration of the annealing.

In the following process step, illustrated in Fig. 1g, the remainder of the source substrate 13 is detached from the handle substrate 2 on which a thin layer 14 of the original source substrate 1 is attached to create the SOQ structure 15. To achieve the detachment, additional energy needs to be applied which is, in particular, done by introducing a blade at the position of the predetermined splitting area. Eventually final detachment may also be achieved by a further thermal annealing step.

Following the detachment a further surface treatment may be carried out to provide the SOQ structure 15 with the required surface properties.

In the described embodiment the reflectivity is determined as a measure of the degree of weakening, but other optical measurements are also be suitable to determine a quantitative or qualitative value for the degree of weakening. That is also transmission may be measured, especially in the case when both the source substrate and the handle substrates are transparent. Another possibility could be to use infrared light or x-rays to obtain the necessary information concerning the maturity of the cavities. Of particular interest therein is the manufacturing process of ultra thin SOI structures wherein a determination of the degree of weakening is important due to the thin silicon layer. As in this example the source and handle wafer are not transparent in the visible regime, it would be advantageous to use infrared or x-rays to obtain the necessary information.

The abovementioned process has been explained using the Smart Cut technology to manufacture SOQ wafers but the invention may also be employed in other processes capable of manufacturing material compound wafers.

Fig. 2 illustrates an embodiment of the thermal annealing device 20 used in the manufacturing process of a material compound wafer 15 for weakening the source substrate 1 at the predetermined splitting area 3. Elements having the same reference numerals in Figs. 1a - g and 2 correspond to the same elements and therefore have the same characteristics. The thermal annealing device 20 is, for example, based on a standard oven used for thermal annealing and comprises in addition a means for determining the degree of weakening of the weakened predetermined splitting area. In this embodiment for determining the degree of weakening a light source 8 and a detector 10 are provided having the same features and properties as the ones explained with respect to Fig. 1e.

The light source 8 and the detecting means 10 are linked to an analyzing means 21 which computes the degree of weakening and may output it to the operator, e.g. in a graphical way. In a further variant the analyzing means 21 may be connected to the control means 22 of the thermal annealing device to provide the control means 22 with instructions to change the temperature of the heating element 23 or to provide a stop signal to stop the annealing process. Instead of a reflectometer an ellipsometer may also be employed to determine the degree of weakening. Thereto a polarizer 24 (in dotted lines) is placed after the light source 8 and an analyzer 25 (in dotted lines) is placed in front of the detector 10.

Fig. 3 shows an example of a reflectivity measurement of a SOQ wafer ob tained in the way described with respect to Figs. 1e and f. Implantation occurred at a rate of 6*10¹⁶at/m² with ions of an energy of 52keV. The y axis corresponds to the measured intensity (in arbitrary units) and the x axis to the wavelength (in nanometers). The solid line indicates the measured reflectivity as a function of wavelength prior to the thermal annealing step and the dotted line shows the change occurring during the thermal annealing step (after about 4.5hrs at a temperature of 390°C). In the example a range of wavelengths is employed. However, as shown by the solid line at about 600 nm, information concerning the degree of weakening can also be obtained from a single wavelength measurement, namely the degree of weakening can be defined as being the ratio between the intensity at about 600 nm during thermal annealing and the intensity at about 600 nm prior to annealing

## Claims

1. Method for manufacturing a material compound wafer, in particular a heterogeneous material compound, more in particular a heterogeneous material compound comprising at least two materials with different physical and/or chemical properties, in particular with different thermal expansion coefficients, comprising the steps of:
- forming a predetermined splitting area (3) in a source substrate (1);
- attaching the source substrate (1) to a handle substrate (2) to form a source-handle-compound (6); and
- thermal annealing of the source substrate (1) for weakening of the source substrate (1) at the predetermined splitting area (3);
wherein a degree of weakening characterizing the physical strength of the connection between the two parts (13, 14) of the source substrate (1) delimited from each other by the weakened predetermined splitting area (3), is determined during and/or after the thermal annealing step
**characterized in that**
the degree of weakening is determined more than once, in particular continuously or periodically, and **in that**
the duration and/or the annealing temperature is/are adapted depending on the evolution of the degree of weakening.

2. Method for manufacturing a material compound according to claim 1,
**characterized in that**
the degree of weakening is determined in-situ.

3. Method for manufacturing a material compound according to claim 1 or 2,
**characterized in that**
the thermal annealing step is stopped, in particular automatically, when the degree of weakening corresponds to a predetermined value.

4. Method for manufacturing a material compound according to at least one of claims 1 to 3,
**characterized in that**
the degree of weakening is determined by measuring an optical property of the source substrate, in particular of the weakened predetermined splitting area.

5. Method for manufacturing a material compound according to claim 4,
**characterized in that**
the optical property is measured in the visible range and/or in the x-ray range, in particular the soft X-ray range, and/or in the infrared range.

6. Method for manufacturing a material compound according to one of claims 4 or 5,
**characterized in that**
the degree of weakening is determined by measuring the reflectivity or the transmission of the source-handle-compound (6), in particular of the weakened predetermined splitting area (3).

7. Method for manufacturing a material compound according to at least one of claims 4 to 6,
**characterized in that**
the degree of weakening is determined by comparing the measured optical property during and/or after the thermal annealing step with the optical property measured prior to the thermal annealing.

8. Method for manufacturing a material compound according to at least one of claims 4 to 7,
**characterized in that**
the reflectivity or transmission is measured with one wavelength.

9. Method for manufacturing a material compound according to at least one of claims 6 to 7,
**characterized in that**
the reflectivity or the transmission is measured for a predetermined range of wavelengths, in particular from 400 nm to 1600 nm.

10. Method for manufacturing a material compound according to one of claims 1 to 9,
**characterized in that**
the handle substrate (2) is transparent and that the degree of weakening is determined by performing measurements through the handle substrate (2).

11. Use of a device determining the degree of weakening according to the method according to one of claims 1 to 10 in a thermal annealing device (20).

## Patentansprüche

1. Verfahren zum Herstellen eines Verbundmaterial-Wafers, insbesondere eines heterogenen Verbundmaterials, das wenigstens zwei Materialien mit unterschiedlichen physikalischen und/oder chemischen Eigenschaften, insbesondere mit unterschiedlichen Wärmeausdehnungskoeffizienten, umfasst, wobei es die folgenden Schritte umfasst:
- Ausbilden eines vorgegebenen Spaltbereiches (3) in einem Ausgangssubstrat (1);
- Anbringen des Ausgangssubstrats (1) an einem Handhabungssubstrat (2), um ein Verbundmaterial aus Ausgangs- und Handhabungsmaterial auszubilden; und
- Wärmebehandeln des Ausgangssubstrates (1), um das Ausgangssubstrat (1) an dem vorgegebenen Spaltenbereich (3) zu schwächen,
wobei ein Grad der Schwächung, der die physikalische Festigkeit der Verbindung zwischen den zwei Teilen (13, 14) des Ausgangssubstrats (1) charakterisiert, die voneinander durch den geschwächten, vorgegebenen Spaltbereich (3) abgegrenzt werden, während und/oder nach dem Wärmebehandlungsschritt bestimmt wird,
**dadurch gekennzeichnet, dass**
der Grad der Schwächung mehr als einmal, d.h. kontinuierlich oder periodisch, bestimmt wird, und dass
die Dauer und/oder die Wärmebehandlungstemperatur in Abhängigkeit von der Entwicklung des Grades der Schwächung angepasst wird/werden.

2. Verfahren zum Herstellen eines Verbundmaterials nach Anspruch 1,
**dadurch gekennzeichnet, dass**
der Grad der Schwächung in situ bestimmt wird.

3. Verfahren zum Herstellen eines Verbundmaterials nach Anspruch 1 oder 2,
**dadurch gekennzeichnet, dass**
der Wärmebehandlungsschritt unterbrochen wird, und zwar automatisch, wenn der Grad der Schwächung einem vorgegebenen Werte entspricht.

4. Verfahren zum Herstellen eines Verbundmaterials nach wenigstens einem der Ansprüche 1 bis 3,
**dadurch gekennzeichnet, dass**
der Grad der Schwächung bestimmt wird, indem eine optische Eigenschaft des Ausgangssubstrats, insbesondere des geschwächten vorgegebenen Spaltbereiches, gemessen wird.

5. Verfahren zum Herstellen eines Verbundmaterials nach Anspruch 4,
**dadurch gekennzeichnet, dass**
die optische Eigenschaft im sichtbaren Bereich und/oder im Röntgenstrahlenbereich, insbesondere im weichen Röntgenstrahlenbereich, und/oder im Infrarot-Bereich gemessen wird.

6. Verfahren zum Herstellen eines Verbundmaterials nach einem der Ansprüche 4 oder 5,
**dadurch gekennzeichnet, dass**
der Grad der Schwächung bestimmt wird, indem der Reflexionsgrad oder der Durchlassgrad des Verbundmaterials (6) aus Ausgangs-und Handhabungsmaterial, insbesondere des geschwächten vorgegebenen Spaltbereiches (3), gemessen wird.

7. Verfahren zum Herstellen eines Verbundmaterials nach wenigstens einem der Ansprüche 4 bis 6,
**dadurch gekennzeichnet, dass**
der Grad der Schwächung bestimmt wird, indem die während des Wärmebehandlungsschrittes und/oder danach gemessene optische Eigenschaft mit der vor der Wärmebehandlung gemessenen optischen Eigenschaft verglichen wird.

8. Verfahren zum Herstellen eines Verbundmaterials nach wenigstens einem der Ansprüche 4 bis 7,
**dadurch gekennzeichnet, dass**
der Reflexionsgrad oder der Durchlassgrad mit einer Wellenlänge gemessen wird.

9. Verfahren zum Herstellen eines Verbundmaterials nach wenigstens einem der Ansprüche 6 bis 7,
**dadurch gekennzeichnet, dass**
der Reflexionsgrad oder der Durchlassgrad für einen vorgegebenen Bereich von Wellenlängen, insbesondere von 400 nm bis 1600 nm, gemessen wird.

10. Verfahren zum Herstellen eines Verbundmaterials nach einem der Ansprüche 1 bis 9,
**dadurch gekennzeichnet, dass**
das Handhabungs-Substrat (2) transparent ist und der Grad der Schwächung bestimmt wird, indem Messungen durch das Handhabungs-Substrat (2) hindurch durchgeführt werden.

11. Verwendung einer Vorrichtung, die den Grad der Schwächung gemäß dem Verfahren nach einem der Ansprüche 1 bis 10 bestimmt, in einer Wärmebehandlungsvorrichtung (20).

## Revendications

1. Procédé de fabrication d'une tranche de composé de matériau, en particulier un composé de matériau hétérogène, plus particulièrement un composé de matériau hétérogène comprenant au moins deux matériaux de propriétés physiques et/ou chimiques différentes, présentant en particulier des coefficients de dilatation thermique différents, comprenant les étapes consistant à :
- former une zone de séparation prédéterminée (3) dans un substrat source (1) ;
- fixer le substrat source (1) à un substrat de manipulation (2) pour former un composé de manipulation source (6) ; et
- effectuer un recuit thermique du substrat source (1) pour affaiblir le substrat source (1) au niveau de la zone de séparation prédéterminée (3) ;
dans lequel un degré d'affaiblissement caractérisant la résistance physique du raccordement entre les deux parties (13, 14) du substrat source (1) délimitées l'une de l'autre par la zone de séparation prédéterminée affaiblie (3) est déterminé pendant et/ou après l'étape de recuit thermique,
**caractérisé en ce que**
le degré d'affaiblissement est déterminé plus d'une fois, notamment de manière continue ou périodique, et **en ce que**
la durée et/ou la température du recuit sont adaptées en fonction de l'évolution du degré d'affaiblissement.

2. Procédé de fabrication d'un composé de matériau selon la revendication 1,
**caractérisé en ce que**
le degré d'affaiblissement est déterminé in situ.

3. Procédé de fabrication d'un composé de matériau selon la revendication 1 ou 2,
**caractérisé en ce que**
l'étape de recuit thermique est interrompue, notamment automatiquement, lorsque le degré d'affaiblissement correspond à une valeur prédéterminée.

4. Procédé de fabrication d'un composé de matériau selon au moins l'une des revendications 1 à 3,
**caractérisé en ce que**
le degré d'affaiblissement est déterminé par la mesure d'une propriété optique du substrat source, notamment de la zone de séparation prédéterminée affaiblie.

5. Procédé de fabrication d'un composé de matériau selon la revendication 4,
**caractérisé en ce que**
la propriété optique est mesurée dans la plage visible et/ou dans la plage de rayons X, notamment la plage de rayons X mous, et/ou dans la plage infrarouge.

6. Procédé de fabrication d'un composé de matériau selon l'une des revendications 4 ou 5,
**caractérisé en ce que**
le degré d'affaiblissement est déterminé par la mesure de la réflectivité ou de la transmission du composé de manipulation source (6), notamment de la zone de séparation prédéterminée affaiblie (3).

7. Procédé de fabrication d'un composé de matériau selon au moins l'une des revendications 4 à 6,
**caractérisé en ce que**
le degré d'affaiblissement est déterminé par comparaison de la propriété optique mesurée pendant et/ou après l'étape de recuit thermique avec la propriété optique mesurée avant le recuit thermique.

8. Procédé de fabrication d'un composé de matériau selon au moins l'une des revendications 4 à 7,
**caractérisé en ce que**
la réflectivité ou transmission est mesurée avec une longueur d'onde.

9. Procédé de fabrication d'un composé de matériau selon au moins l'une des revendications 6 à 7,
**caractérisé en ce que**
la réflectivité ou la transmission est mesurée pour une plage prédéterminée de longueurs d'onde, notamment de 400 nm à 1 600 nm.

10. Procédé de fabrication d'un composé de matériau selon l'une des revendications 1 à 9,
**caractérisé en ce que**
le substrat de manipulation (2) est transparent et **en ce que** le degré d'affaiblissement est déterminé par la réalisation de mesures à travers le substrat de manipulation (2).

11. Utilisation d'un dispositif déterminant le degré d'affaiblissement selon le procédé selon l'une des revendications 1 à 10, dans un dispositif de recuit thermique (20).
